# EUROPÄISCHE PATENTANMELDUNG

(11) **EP 2 405 442 A1**
(43) Veröffentlichungstag der Anmeldung: **11.01.2012**
(21) Anmeldenummer: 10166539.6
(22) Anmeldetag: 18.06.2010
(51) Int. Cl.: G11C 16/10

(54) **Chipkarte mit zwei Speichern**

(71) Anmelder: Morpho Cards GmbH, 24220 Flintbek (DE)
(72) Erfinder: Konze, Bernhard, 33100 Paderborn (DE); Kulinna, Michael, 33098 Paderborn (DE); Winter, Christian, 33378 Rheda-Wiedenbrück (DE)
(74) Vertreter: Richardt Patentanwälte

(57) **Zusammenfassung**

Die Erfindung betrifft ein Verfahren zum sicheren Speichern von Daten in einem ersten nichtflüchtigen, wieder beschreibbaren Speicher (310) einer Chipkarte (304), wobei die Chipkarte (304) ferner einen zweiten nichtflüchtigen, wieder beschreibbaren Speicher (312) aufweist, wobei sich der Speichertyp des ersten nichtflüchtigen, wieder beschreibbaren Speichers vom Speichertyp des zweiten nichtflüchtigen, wieder beschreibbaren Speichers unterscheidet, wobei das Verfahren die Schritte umfasst:
- Empfang (100) von Daten,
- Schreiben (102) der Daten in den zweiten Speicher (312),
- Registrieren (104) eines erfolgreichen Schreibvorgangs aller Daten in den zweiten Speicher (312),
- Schreiben (106) der Daten in den ersten Speicher (310),
- Registrieren (110) eines erfolgreichen Schreibvorgangs aller Daten in den ersten Speicher (310).

## Beschreibung

Die Erfindung betrifft ein Verfahren zum sicheren Speichern von Daten auf einer Chipkarte, ein Computerprogrammprodukt sowie eine Chipkarte zum sicheren Speichern von Daten.

Chipkarten kommen heutzutage in vielerlei technischen Gebieten zur Anwendung. Eine der Anwendungen von Chipkarten ist beispielsweise die Verwendung als Kreditkarte oder Bankkarte.

Einen Überblick über Chipkarten und deren Architektur findet sich beispielsweise im "Handbuch der Chipkarten" (Carl Hanser Verlag München-Wien; 2002; 4. überarbeitete Auflage).

Eine Chipkarte umfasst üblicherweise neben einem Mikroprozessor zur Ausführung von Computerprogrammen auf der Chipkarte ein Masken-ROM, ein EEPROM, ein RAM sowie ein I/O-Port. Das Masken-ROM enthält dabei das Betriebssystem der Chipkarte und wird während der Herstellung fest vorgegeben. Der Inhalt des ROM ist herstellungsbedingt für alle Chips eines Produktionszyklus identisch und während der Lebensdauer des Chips unveränderbar.

Das EEPROM ist der nichtflüchtige, wiederbeschreibbare Speicherbereich des Chips, in dem Daten oder auch Programmcodes unter Kontrolle des Betriebssystems geschrieben und gelesen werden können. Das RAM ist der Arbeitsspeicher des Prozessors, genauer gesagt des Microcontrollers der Chipkarte. Dieser Speicherbereich ist flüchtig und alle darin gespeicherten Daten gehen verloren, wenn die Versorgungsspannung des Chips abgeschaltet wird.

Die serielle I/O-Schnittstelle besteht meistens aus einzigem Register, über welches die Daten Bit für Bit an entsprechende externe Geräte übertragen werden können.

Mikroprozessorkarten sind in der Anwendung sehr flexibel. Im einfachsten Fall enthalten sie ein auf eine einzige Anwendung hin optimiertes Programm und sind somit auch nur für diese eine Anwendung verwendbar. Moderne Chipkarten-Betriebssysteme ermöglichen jedoch, verschiedene Anwendungen in einer einzigen Karte zu integrieren. Das ROM enthält in diesem Fall nur die Basiskommandos des Betriebssystems, während die anwendungsspezifischen Teile des Programms erst nach der Kartenproduktion in das EEPROM geladen werden. Neue Entwicklungen ermöglichen es sogar, Anwendungen in die Chipkarte nachzuladen, nachdem die Karte personalisiert und an den Kartenbenutzer ausgegeben wurde. Durch entsprechende Hardware- und Softwaremaßnahmen wird hierbei sichergestellt, dass die unterschiedlichen Sicherheitsbedingungen der einzelnen Anwendungen hierbei nicht verletzt werden. Speziell hierfür optimierte Mikroprozessorchips mit hoher Rechenleistung und Speicherkapazität sind mittlerweile verfügbar.

Wie bereits erwähnt, dient das EEPROM (Electrical Erasable Read Only Memory) dazu, Daten und Programme zu speichern, die ggf. verändert oder gelöscht werden sollen. Ferner können auf einem EEPROM beliebige Daten gespeichert werden, welche ebenfalls im Lauf der Zeit verändert oder gelöscht werden sollen. Ein wesentliches Merkmal von EEPROMs ist, dass im EEPROM enthaltene Daten auch ohne Stromzufuhr erhalten bleiben. Ein EEPROM ist also ein nichtflüchtiger Speicher. Eine EEPROM-Zelle stellt dem Prinzip nach einen winzigen Kondensator dar, der geladen oder entladen sein kann. Der Ladezustand kann durch eine Art Sensorik abgefragt werden. Um nun eine Speicherzelle zu beschreiben, muss diese zunächst gelöscht werden. Jedem Speichervorgang geht also ein Löschvorgang voraus.

Das EEPROM ist einer der Halbleiterspeicher, die eine begrenzte Anzahl von Zugriffen haben: Gelesen werden kann dieser Speicher unbegrenzt oft, jedoch ist die Anzahl der Programmierungen limitiert. Der Grund für diese Begrenzung ist im halbleitertechnischen Aufbau des Speichers zu sehen. Oftmals wird für die Software im Microcontroller der Chipkarte gefordert, dass bestimmte Teile von ihr entweder vollständig oder gar nicht durchlaufen werden. Abläufe, die nicht aufteilbar sind und diese Forderung erfüllen, nennt man deshalb auch atomare Abläufe. Sie treten immer in Verbindung mit EEPROM-Schreibroutinen auf. Atomaren Abläufen liegt der Gedanke zugrunde, dass beim Schreiben ins EEPROM sichergestellt werden soll, dass die betreffenden Daten in keinem Fall nur teilweise geschrieben worden sind. Dies würde beispielsweise dann der Fall sein, wenn der Benutzer die Chipkarte im falschen Augenblick aus einem entsprechenden zugehörigen Terminal zieht oder es zu einem plötzlichen Stromausfall kommt.

Da die Chipkarte über keinerlei Pufferspeicher für elektrische Energie verfügt, verliert die Software in der Karte in diesen Fällen sofort die Aktionsmöglichkeiten, Vor allem bei elektronischen Geldbörsen auf Chipkarten muss unter allen Umständen sichergestellt sein, dass die Anträge in den Dateien vollständig und korrekt sind. Beispielsweise wäre es hier äußerst fatal, wenn der Saldo einer Börse einer Chipkarte durch das Ziehen der Karte aus dem Terminal nur unvollständig auf den neuesten Stand gebracht werden würde. Auch müssen die entsprechenden Einträge in den Protokolldateien immer vollständig sein.

Da die Hardware von Chipkarten atomare Abläufe nicht unterstützt, müssen diese deshalb mit Software realisiert werden.

Eine Variante, die bei Chipkarten-Betriebssystemen Verwendung findet, ist nachfolgend in ihren grundlegenden Abläufen beschrieben. Dieses Fehlerbehebungsverfahren (Error Recovery) ist transparent zur äußeren Welt und erfordert dadurch keinerlei Änderungen in evtl. bestehenden Anwendungen.

Zur Beschreibung dieses Verfahrens sei angenommen, dass über die Schnittstelle der Chipkarte Daten gesandt werden, welche für eine Datei bestimmt sind. Im EEPROM-Teil des Betriebssystems selber ist ein Puffer (auch Zwischenspeicher genannt) eingerichtet, der ausreichend groß ist, um alle notwendigen Daten aufzunehmen. Üblicherweise ist dieser Zwischenspeicher ebenfalls im EEPROM eingerichtet und ausreichend groß, um alle notwendigen Daten aufzunehmen. Der Zwischenspeicher besitzt ein Kennzeichen, zum Beispiel einen Flag, einen PufferFlag oder ein Statusbyte, für den Zustand. Dieses kann entweder auf "Daten im Puffer gültig" oder auf "Daten im Puffer ungültig" gesetzt sein. Zusätzlich zum Puffer muss noch ein entsprechender Speicher für die Zieladresse und die aktuelle Länge der Pufferdaten vorhanden sein.

Der konkrete Ablauf stellt sich nun folgendermaßen dar: Die Daten, die sich auf der Zieladresse befinden, beispielsweise in einer Datei, werden im ersten Schritt unter Angabe der physikalischen Adresse und ihrer Länge nach Löschen des Puffers in den Puffer kopiert. Nun wird das Flag für den Pufferinhalt auf "Daten im Puffer gültig" gesetzt. Im nächsten Schritt kopiert das Betriebssystem die neuen Daten an die gewünschte Adresse, wobei zunächst die Daten an dieser Daten gelöscht werden müssen, und ändert das Flag nach einem weiteren Löschungsvorgang wieder auf "Daten im Puffer ungültig". Zum Beispiel beim Hochfahren des Betriebssystems vor dem ART (Answer to Reset) wird das Flag abgefragt. Ist es auf "Daten im Puffer gültige" gesetzt, findet automatisch ein Schreibvorgang der im Puffer befindlichen Daten in den ebenfalls gespeicherten Adressbereich statt. Das Verfahren kann natürlich für die parallele Verarbeitung mehrerer Datenelemente kaskadiert werden. Mit diesem Mechanismus ist somit in jedem Fall gewährleistet, dass gültige Daten in der Datei stehen.

Kommt es in irgendeiner Stelle im Programmablauf zum Abbruch der Routine, so können die Daten im EEPROM der Chipkarte wieder restauriert werden. Zieht beispielsweise beim Schreiben der neuen Daten im EEPROM der Benutzer die Chipkarte, so stehen die neuen Daten nur teilweise in der Datei. Beim Einschalten der Karte bei der nächsten Sitzung merkt das Betriebssystem, dass sich gültige Daten im Puffer befinden, und kopiert diese an die entsprechende Stelle. Damit ist der ursprüngliche Zustand wieder hergestellt und alle Einträge in den Dateien im EEPROM sind konsistent.

Der beschriebene Ablauf gemäß dem Stand der Technik hat jedoch zwei gravierende Nachteile: Der Pufferspeicher wird am stärksten von allen EEPROM-Bereichen durch Schreiben und Löschen belastet. Weil die Anzahl der Schreib-/Löschzyklen des EEPROMs begrenzt ist, erhält man damit in dem wichtigen Puffer mit hoher Wahrscheinlichkeit einen teilweisen Ausfall von Speicherbereichen in Form eines Schreibfehlers. Dies würde jedoch bedeuten, dass man die Chipkarte daraufhin nicht wieder verwenden kann, da die Datenkonsistenz nicht mehr gewährleistet ist. Zwar könnte dieses Problem dadurch entschärft werden, indem man den Puffer zyklisch aufbaut, sodass nicht immer an die gleiche Stelle geschrieben werden muss. Allerdings benötigt man in diesem Fall für den Puffer unverhältnismäßig viel EEPROM.

Ein weiterer Nachteil der Realisierung des obig beschriebenen atomaren Ablaufs ist die Verlängerung der Programmausführungszeiten aufgrund der obligatorischen Schreibzugriffe in den Pufferspeicher. In ungünstigsten Fällen dauert aufgrund dieses Mechanismus der Zugriff dreimal länger als bei direktem Schreiben in den EEPROM-Speicher. Deshalb ist es üblich, nicht alle EEPROM-Zugriffe zu puffern, sondern nur Schreibzugriffe auf bestimmte Dateien oder Datenelemente im EEPROM. Dies kann bei Dateien beispielsweise durch Attribute im Header jeweils festgelegt werden.

Demgegenüber liegt der vorliegenden Erfindung die Aufgabe zugrunde, ein verbessertes Verfahren zum sicheren Speichern von Daten auf einer Chipkarte, ein verbessertes Computerprogrammprodukt sowie eine verbesserte Chipkarte zu schaffen.
Die der Erfindung zugrundeliegenden Aufgaben werden durch die Merkmale der unabhängigen Patentansprüche gelöst. Bevorzugte Ausführungsformen der Erfindung sind in den abhängigen Patentansprüchen angegeben.

Es wird ein Verfahren zum sicheren Speichern von Daten in einen ersten nichtflüchtigen, wiederbeschreibbaren Speicher einer Chipkarte geschaffen, wobei die Chipkarte ferner einen zweiten, nichtflüchtigen, wiederbeschreibbaren Speicher aufweist, wobei sich der Speichertyp des ersten, nichtflüchtigen wiederbeschreibbaren Speichers vom Speichertyp des zweiten, nichtflüchtigen wiederbeschreibbaren Speichers unterscheidet, wobei das Verfahren die Schritte umfasst des Empfangs von Daten, des Schreibens der Daten in den zweiten Speicher, des Registrierens eines erfolgreichen Schreibvorgangs aller Daten in den zweiten Speicher, des Schreibens der Daten in den ersten Speicher und des Registrierens eines erfolgreichen Schreibvorgangs aller Daten in den ersten Speicher.

Ausführungsformen der Erfindung haben den Vorteil, dass die Ausfallsicherheit entsprechender Chipkarten signifikant erhöht wird, da als zweiter Speicher solche Speichertypen verwendet werden können, welche eine sehr hohe Anzahl von Schreib-Lesezugriffen ermöglichen. Nichtsdestotrotz müssen in Bezug auf den ersten Speicher keine Abstriche gemacht werden, was die dortige Datensicherheit in Bezug auf langlebige Datenspeicherung beeinträchtigen würde.

Ferner kann als zweiter Speicher insbesondere ein Speicher eingesetzt werden, welcher wesentlich schneller ist als der erste Speicher. Damit werden die Programmausführungszeiten nicht wesentlich verlängert, trotz der Verwendung des Pufferspeichers in Form des zweiten Speichers. Damit ist es sogar möglich, sämtliche EEPROM-Zugriffe zu puffern, wodurch die Ausfallsicherheit einer entsprechenden Chipkarte signifikant erhöht wird. Wie bereits erwähnt, kann nichtsdestotrotz als erster Speicher ein konventioneller erster Speicher, beispielsweise ein EEPROM, verwendet werden, sodass nichtsdestotrotz mit einer entsprechenden Chipkarte die bewährten positiven Eigenschaften von EEPROMs in der Chipkarte genützt werden können.

Ein weiterer Vorteil von Ausführungsformen der Erfindung ist, dass die interne Programmlogik von entsprechenden Chipkarten vereinfacht wird, da nicht mehr zwischen "atomaren, sicheren" Schreibvorgängen von kritischen Daten und "normalen" Schreibvorgängen von unkritischen Daten unterschieden werden muss. Sämtliche Schreibvorgänge können nun grundsätzlich immer unter Verwendung beider Speicher durchgeführt werden. Durch die entsprechend intern einfachere Programmlogik der Chipkarte können somit sogar Geschwindigkeitsvorteile im Programmablauf erzielt werden. Ebenfalls Vorteil ist damit einhergehend die geringere Fehleranfälligkeit für Software-Fehler aufgrund der vereinfachten internen Programmlogik.

Außerdem besteht damit die Möglichkeit, auszuschließen, dass kritische Daten (die atomar geschrieben werden sollten) vom Software-Entwickler als nicht kritisch bei der Programmierung beurteilt werden und somit dieser Entwickler das atomare, sichere Schrieben für diese Daten nicht implementiert. Damit wird wiederum die Fehleranfälligkeit reduziert.

Damit kann insgesamt ein schnelleres und sicheres Verfahren zum Beschreiben von EEPROMs bereitgestellt werden, welches zudem auch noch kostengünstig ist, da als zweiter Speicher insbesondere auch solche Speichertypen gewählt werden können, welche in kostengünstiger Weise hergestellt werden können.

Nach einer Ausführungsform der Erfindung erfolgt das Registrieren des erfolgreichen Schreibvorgangs aller Daten in den zweiten Speicher und das Registrieren des erfolgreichen Schreibvorgangs aller Daten in den ersten Speicher über zumindest ein Flag. Ebenfalls nach einer Ausführungsform der Erfindung erfolgt das Registrieren des erfolgreichen Schreibvorgangs aller Daten in den ersten Speicher durch Löschen des Flags, welcher zur Registrierung des erfolgreichen Schreibvorgangs aller Daten in den zweiten Speicher gesetzt wurde.

Während es sich bei dem ersten Speicher beispielsweise um ein EEPROM oder einen Flash-EEPROM-Speicher handelt, handelt es sich bei dem ersten Speicher vorzugsweise um einen NVRAM-Speicher, beispielsweise einem FRAM- oder MRAM- oder PRAM-Speicher.

Besonders bevorzugt wird in der vorliegenden Erfindung die Verwendung eines FRAM-(Ferroelectric Random Access Memory) Speichers. Ein FRAM-Speicher ist kein flüchtiger Speicher wie das RAM, sondern es behält seinen Inhalt auch ohne Versorgungsspannung bei. Bei dieser Speicherart benutzt man zur Speicherung von Informationen die Eigenschaften von ferroelektrischen Substanzen. Gerade für Chipkarten ist diese Speicherart ideal, da sie alle gewünschten Eigenschaften eines optimalen Speichers aufweist. So wird zur Programmierung nur 5 V oder weniger benötigt (z.B. 3V oder gar nur 1,8V), wobei sich die Programmierzeit lediglich im Bereich von 100 ns bewegt und die Zahl der möglichen Programmierzyklen im Bereich einer Billion liegt.

Ein wesentliches Merkmal von FRAM-Speichern besteht darin, dass beim Lesen von FRAM-Zellen deren Inhalt zerstört wird. Dies bedeutet, dass nach dem Lesen von Daten aus dem FRAM diese Daten im FRAM nicht mehr vorhanden sind.

Nach einer Ausführungsform der Erfindung erfolgt das Registrieren des erfolgreichen Schreibvorgangs aller Daten in den ersten Speicher durch Löschen des Flags, welcher zur Registrierung des erfolgreichen Schreibvorgangs aller Daten in den zweiten Speicher gesetzt wurde. Damit kann unter Verwendung eines einzelnen Flags in Form von "Flag gesetzt" oder "Flag nicht gesetzt" bestimmt werden, ob Daten im zweiten Speicher vorliegen, welche noch in den ersten Speicher geschrieben werden müssen, um einen entsprechenden Datenspeicherungsvorgang abzuschließen.

Nach einer weiteren Ausführungsform der Erfindung wird überprüft, ob kein erfolgreicher Schreibvorgang aller Daten in den ersten Speicher erfolgt ist. Wurde beispielsweise ein Schreibvorgang der Daten in dem ersten Speicher durch einen Stromausfall oder durch eine manuelle Entfernung einer Chipkarte aus einem entsprechenden Lesegerät abgebrochen, so zeigt sich dies bei der Verwendung eines Flags darin, dass dieses Flag gesetzt ist. Bei erneuter Bestromung der Chipkarte kann somit dieser Flag gelesen werden, dadurch detektiert werden, dass ein Schreibvorgang in den ersten Speicher fehlgeschlagen ist, worauf daraufhin nochmals Daten aus dem zweiten Speicher gelesen werden können. Die aus dem zweiten Speicher gelesenen Daten werden daraufhin in den ersten Speicher geschrieben, wobei nun im Falle eines jetzt erfolgreichen Schreibvorgangs dieser Daten dieser erfolgreiche Schreibvorgang als "der erfolgreiche Schreibvorgang aller Daten in den ersten Speicher" registriert wird. Dies kann beispielsweise wiederum durch Löschen des Flags - bei Verwendung eines Flags - realisiert werden.

Allerdings sei darauf verwiesen, dass dieses Verfahren nicht ausschließlich auf jene Situationen beschränkt ist, in welchen eine Registrierung von erfolgreichen Schreibvorgängen nur dann erfolgt, wenn eine Chipkarte beispielsweise durch Einführung in ein entsprechendes Lesegerät, entsprechend bestromt wird. Denkbar ist nämlich auch im laufenden Betrieb einer Chipkarte in einem Lesegerät entsprechende Überprüfungsvorgänge bezüglich eines erfolgreichen Schreibens von Chipkartendaten in den ersten Speicher zu überprüfen.

Kommt nun als zweiter Speicher ein FRAM zur Anwendung, wobei der besagte Puffer-Flag auf dem FRAM selbst gespeichert ist, so ergeben sich hierdurch wesentliche Vorteile gegenüber dem Stand der Technik. Zur Erläuterung sei hierfür im Einzelnen auf das beschriebene Verfahren eingegangen:

Soll ein neuer Wert in das EEPROM geschrieben werden, wird dieser Wert zum Beispiel zunächst mit seiner Länge und seiner Zieladresse in das FRAM durch den Microcontroller der Chipkarte geschrieben. Danach wird ein sich ebenfalls im FRAM-Speicher befindlicher Puffer-Flag auf den Wert "gültig" gesetzt. Dann wird der EEPROM an der Zieladresse gelöscht und mit dem zu schreibenden Wert durch den Microcontroller beschrieben. Zuletzt wird der Puffer-Flag des FRAMs auf den Wert "ungültig" gesetzt.

Es sei darauf verwiesen, dass das Schreiben der Daten in das EEPROM vorzugsweise aus dem flüchtigen RAM-Speicher der Chipkarte erfolgt. Ein Schreiben aus dem FRAM-Speicher hätte den Nachteil eines Datenverlusts der Daten im FRAM zur Folge, da ein Lesevorgang, wie obig beschrieben, im FRAM gleichzeitig zur Löschung derselben Daten führt.

Bei einem Neustart beim nächsten Betreiben der Chipkarte oder bei einem Neustart nach vorangegangener Unterbrechung durch zum Beispiel einen Stromausfall oder Ziehen der Karte, kann nun als eine der ersten Operationen der Wert dieses Puffer-Flags abgefragt werden.

Hat nun der Puffer-Flag den Wert "ungültig" so wurde die vorangegangene Aktion erfolgreich abgeschlossen. Hat der Puffer-Flag den Wert "gültig", so wurde hingegen die vorangegangene Transaktion unterbrochen. Im ersten Fall kann eine neue Transaktion begonnen werden. Im letzteren Fall hingegen, werden die Daten aus dem FRAM-Zwischenspeicher in die CPU kopiert, wodurch jedoch auch gleichzeitig der Zwischenspeicher gelöscht wird. Danach werden die Daten vorzugsweise wieder zurück in den FRAM-Speicher kopiert, sodass auch bei einem weiteren Stromausfall gewährleistet ist, dass die Daten auf alle Fälle im FRAM-Speicher vorhanden sind. Selbstverständlich muss hier gewährleistet sein, dass der Puffer-Flag nach wie vor den Wert "gültig" aufweist, da ja die Daten noch nicht endgültig ins EEPROM geschrieben wurden.

Danach werden die Daten an der Zieladresse im EEPROM gelöscht und mit den Daten, die sich im flüchtigen RAM befinden, beschrieben. Zuletzt wird der Puffer-Flag wiederum auf den Wert "ungültig" gesetzt.

Gerade durch die Verwendung eines FRAMs ergeben sich gegenüber dem Stand der Technik signifikante Vorteile durch den Wegfall des Löschens-Schritts des Löschens des Puffer-Flags und der Verwendung eines bezüglich der Schreib-Lese-Zyklen wesentlich schnelleren Speichers. Das gesamte Verfahren wird dadurch stabiler und kann somit auf jede Transaktion angewendet werden.

Nach einer Ausführungsform der Erfindung erfolgt somit vor der Durchführung einer bestimmungsgemäßen Verwendung des ersten Speichers die Überprüfung, ob kein erfolgreicher Schreibvorgang aller Daten im ersten Speicher erfolgt ist. Möglich ist jedoch auch, dass die bestimmungsgemäße Verwendung des ersten Speichers lediglich einen Initialisierungsvorgang der Chipkarte umfasst. Beispielsweise wäre dies der Fall, wenn die Chipkarte in ein entsprechendes Lesegerät eingeführt wird, wodurch eine Beströmung der Chipkarte durch das Lesegerät stattfindet. So wird zum Beispiel beim Hochfahren des Betriebssystems vor dem ART (Answer to Reset) das Flag abgefragt.

Nach einer Ausführungsform der Erfindung erfolgt das Registrieren des erfolgreichen Schreibvorgangs aller Daten in den zweiten Speicher und das Registrieren des erfolgreichen Schreibvorgangs aller Daten in den ersten Speicher im zweiten Speicher selbst. In Verbindung mit einem FRAM und der Setzung eines entsprechenden Puffer-Flags wurden entsprechende Vorteile gegenüber dem Stand der Technik obig diskutiert.

Es ist jedoch auch denkbar, dass entsprechende Registrierungen - mit oder ohne Verwendung von Puffer-Flags - an anderer Stelle denkbar wären. So kann ein entsprechender Puffer im Mikroprozessor integriert sein, der Puffer könnte auf dem Chipmodul separat vom ersten und zweiten Speicher integriert sein oder an beliebiger anderer Stelle der Chipkarte.

Nach einer weiteren Ausführungsform der Erfindung ist der zweite Speicher kleiner als der erste Speicher. Dies ist ausreichend und ermöglicht kostengünstig und Platz sparend den zweiten Speicher auf der Chipkarte unterzubringen, denn typischerweise wird der zweite Speicher nur als Puffer benötigt, in dem immer nur ein kleiner Teil des ersten Speichers und eine Zieladresse gespeichert sind.

In einem weiteren Aspekt betrifft die Erfindung ein Computerprogrammprodukt mit von einem Prozessor ausführbaren Instruktionen zur Durchführung des obig beschriebenen Verfahrens.

In einem weiteren Aspekt betrifft die Erfindung eine Chipkarte zum sicheren Speichern von Daten in einem ersten nichtflüchtigen, wiederbeschreibbaren Speicher der Chipkarte, wobei die Chipkarte ferner einen zweiten nichtflüchtigen, wiederbeschreibbaren Speicher aufweist, wobei sich der Speichertyp des ersten nichtflüchtigen, wiederbeschreibbaren Speichers vom Speichertyp des zweiten nichtflüchtigen, wiederbeschreibbaren Speichers unterscheidet, wobei die Chipkarte ferner einen Mikroprozessor aufweist, welcher zur Durchführung der nachfolgenden Schritte ausgebildet ist:
- Empfang von Daten,
- Schreiben der Daten in den zweiten Speicher,
- Registrieren eines erfolgreichen Schreibvorgangs aller Daten in den zweiten Speicher,
- Schreiben der Daten in den ersten Speicher,
- Registrieren eines erfolgreichen Schreibvorgangs aller Daten in den ersten Speicher.

Im Folgenden werden bevorzugte Ausführungsformen anhand der Zeichnungen näher erläutert. Es zeigen:
- Figur 1: eine schematisches Flussdiagramm eines Verfahrens zum sicheren Speichern von Daten,
- Figur 2: ein schematisches Flussdiagramm eines Verfahrens zum sicheren Speichern von Daten,
- Figur 3: eine schematische Ansicht einer Chipkarte mit Lesegerät.

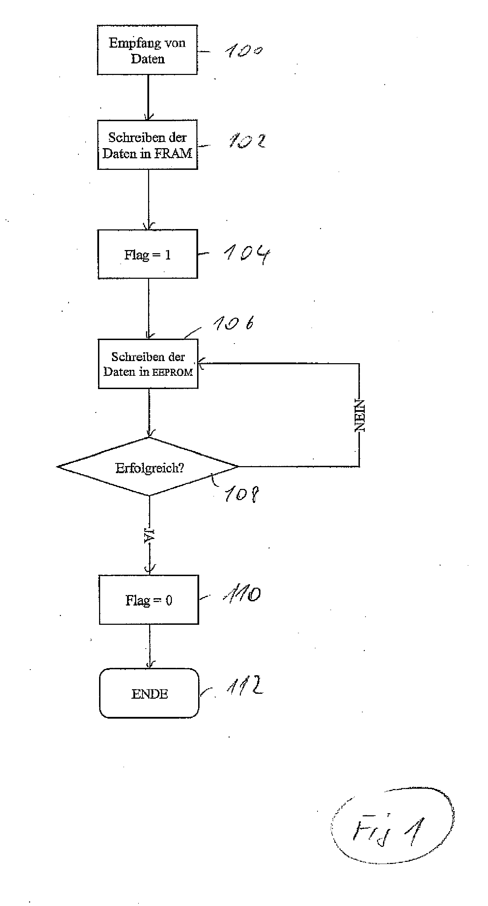

Die Figur 1 zeigt ein schematisches Flussdiagramm eines Verfahrens zum sicheren Speichern von Daten. Hierbei wird ohne Beschränkung der Allgemeinheit davon ausgegangen, dass die Daten in einem EEPROM (erster nichtflüchtiger, wiederbeschreibbarer Speicher einer Chipkarte) gespeichert werden sollen, wobei dies unter Zuhilfenahme eines FRAM-Speichers (zweiter nichtflüchtiger, wiederbeschreibbarer Speicher) erfolgen soll.

Das Verfahren beginnt in Schritt 100 mit dem Empfang von Daten, woraufhin diese Daten im Datenspeicher des Mikroprozessors der Chipkarte festgehalten werden. Von dort werden die Daten und Zieladresse in Schritt 102 in den FRAM-Speicher kopiert, wobei nach Abschluss eines erfolgreichen Kopiervorgangs in Schritt 104 eine Flag im FRAM-Speicher auf den Wert "1" gesetzt wird. Dieser Wert 1 zeigt an, dass ein erfolgreicher Schreibvorgang aller Daten in den FRAM-Speicher erfolgt ist.

Daraufhin erfolgt im Schritt 106 das Schreiben der Daten in den EEPROM-Speicher, indem die Daten aus dem RAM des Mikroprozessors in den EEPROM-Speicher kopiert werden.

In Schritt 108 erfolgt dann die Überprüfung dahingehend, ob das Schreiben aller Daten in den EEPROM-Speicher erfolgreich war. Ist dies, beispielsweise aufgrund eines Schreibfehlers, nicht erfolgreich, so springt das Verfahren zurück zu Schritt 106, wo ein nächster Schreibversuch unternommen wird.

Ist hingegen der Schreibvorgang in Schritt 108 erfolgreich, so wird in Schritt 110 das in Schritt 104 zuvor gesetzte Flag auf den Wert "0" gesetzt. Dies kann beispielsweise einfach dadurch realisiert werden, dass der Puffer-Flag aus Schritt 104 in Schritt 110 gelesen wird, wobei durch den Lesevorgang ein Löschen des Flags aufgrund der physikalischen Grundeigenschaften des FRAMs erfolgt. Dieses Löschen entspricht in dem vorliegenden Fall dem Setzen des Flags auf den Wert "0".

Das Verfahren zur Speicherung von Daten endet daraufhin in Schritt 112.

Handelt es sich nun, wie obig beschrieben, beispielsweise bei der Chipkarte, auf welche das Verfahren in der Figur 1 ausgeführt wird, um eine elektronische Geldbörse (Bankkarte), so kann das Problem bestehen, dass während der Durchführung des Schrittes 106 das Schreiben der Daten in den EEPROM-Speicher unterbrochen wird. Beispielsweise kann ein Benutzer die Karte aus einem entsprechenden Lesegerät entfernen oder aus anderen Gründen kann ein Stromausfall zur Unterbrechung des Schreibvorgangs führen.

Da im Falle einer elektronischen Geldbörse die zu schreibenden Daten beispielsweise von der elektronischen Geldbörse abgebuchte Geldbeträge bzw. aufzubuchenden Geldbeträge umfassen, würde ein Unterbrechen des Schreibvorgangs dazu führen, dass im EEPROM der Chipkarte Transaktionsdaten unvollständig und damit in einem undefinierten Zustand gespeichert werden würden - bei erneuter Verwendung der Chipkarte wäre diese nicht in der Lage, festzustellen, wie die im EEPROM befindlichen Daten in Bezug auf ab- bzw. aufgebuchte Geldbeträge zu interpretieren sind.

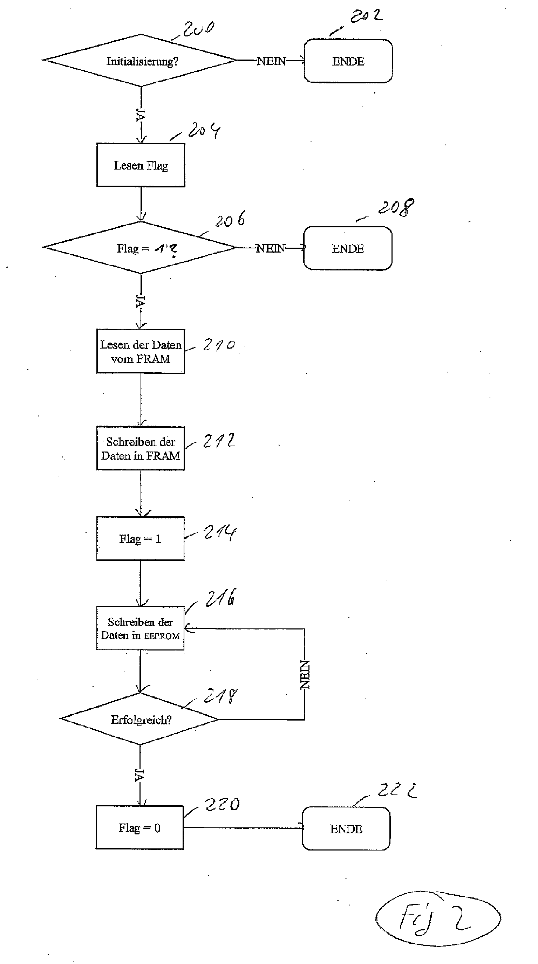

Die Figur 2 zeigt nun eine Lösungsmöglichkeit für diese Problematik. Möglich wäre, dass in der Chipkarte eine feste Routine einprogrammiert ist, welche zunächst überprüft, ob eine Initialisierung in Schritt 200 der Chipkarte gegeben ist. Als Initialisierung wird hierbei eine beliebig festzulegende bestimmungsgemäße Verwendung der Chipkarte bzw. des darin befindlichen EEPROM-Speichers gesehen. Beispielsweise kann als Initialisierungsbedingung eine Bestromung der Chipkarte durch Einführung in ein Kartenlesegerät gesehen werden.

Liegt keine Initialisierung vor, d.h. bei Durchführung des Schrittes 200 befindet sich die Chipkarte bereits seit längerer Zeit ohne jedwede Probleme im entsprechenden Lesegerät, so endet das Verfahren daraufhin unmittelbar im Schritt 202.

Stellt jedoch der Mikroprozessor der Chipkarte in Schritt 200 fest, dass eine Initialisierung der Chipkarte aufgrund eines Einführens in ein Lesegerät stattgefunden hat, so erfolgt in Schritt 204 das Lesen des Flags vom FRAM. Ist der Flag im FRAM nicht gesetzt (Flag = 0), so zeigt dies z.B. an, dass in Schritt 106 (vgl. Figur 1) ein Schreibvorgang von Daten in den EEPROM-Speicher erfolgreich war. Dies führt unmittelbar zum Ende des Verfahrens mit Schritt 208. Ist hingegen der Flag besetzt, so weist dies darauf hin, dass in einem vorher erfolgten Schreibverfahren von Daten in dem EEPROM-Speicher die Schritte 106 - 112 (vgl. Figur 1) nicht vollständig ausgeführt werden konnten. Dies kann beispielsweise aus einer Unterbrechung während dem Schreibvorgang in Schritt 106 im EEPROM-Speicher resultieren. In diesem Fall sind nicht alle Daten vollständig im EEPROM-Speicher gespeichert.

Ist nun also in Schritt 206 das Resultat, dass der Puffer-Flag gesetzt ist, so erfolgt daraufhin in Schritt 210 das Lesen der Daten vom FRAM-Speicher in den RAM-Speicher des Mikroprozessors. Da ein solches Datenlesen vom FRAM auch gleichzeitig ein Löschen dieser Daten im FRAM-Speicher bedeutet, sollte daraufhin vorzugsweise eine erneute Kopie der nun im RAM befindlichen Daten in den FRAM-Speicher in Schritt 212 geschrieben werden. Allerdings ist dieser Schritt optional.

Da ebenfalls durch das Lesen des Flags in Schritt 204 der Flag aus dem FRAM-Speicher gelöscht wurde, sollte ebenfalls in dem optionalen Schritt 214 der Flag wiederum auf 1 gesetzt werden.

Daraufhin erfolgt in Schritt 216 wiederum das Schreiben der im RAM-Speicher befindlichen Daten in den EEPROM-Speicher, woraufhin in Schritt 218 überprüft wird, ob der Schreibvorgang erfolgreich war. Ist dies nicht der Fall, springt das Verfahren erneut zu Schritt 216 und ein erneuter Schreibvorgang der Daten in den EEPROM-Speicher findet statt.

Ist der Schreibvorgang hingegen erfolgreich, so springt daraufhin das Verfahren zu Schritt 220, wo der Flag gelöscht wird (Flag = 0), woraufhin in Schritt 222 das Verfahren endet. Es sei angemerkt, dass hier die Schritte 210-220 im Wesentlichen identisch sind zu den Schritten 102-112 der Figur 1.

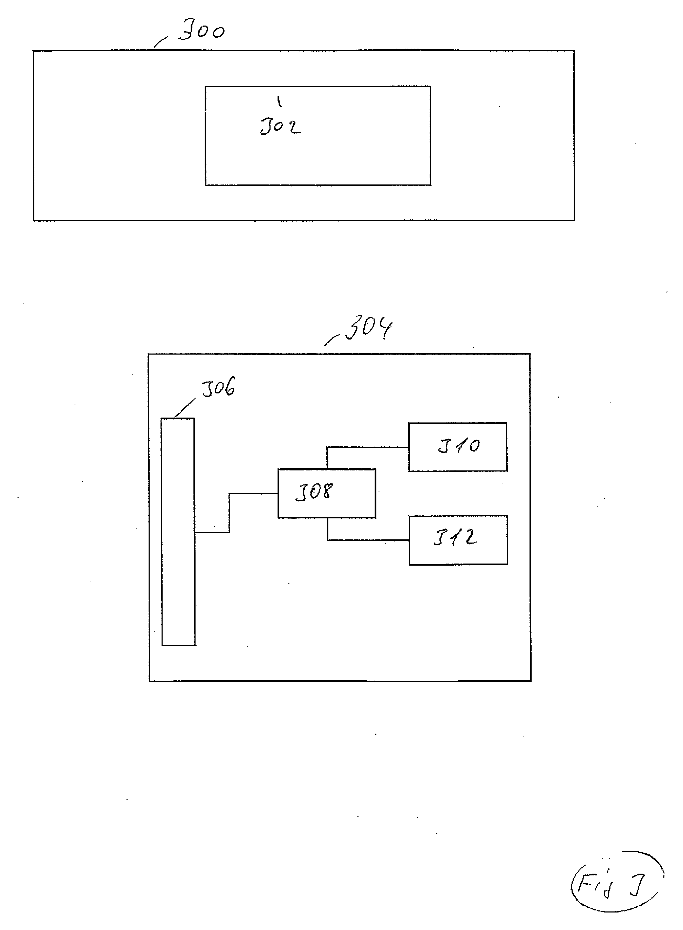

Die Figur 3 zeigt ein schematisches Blockdiagramm einer Chipkarte 304 und ein der Chipkarte zugeordnetes entsprechendes Lesegerät 300. Sowohl die Chipkarte 304 als auch das Lesegerät 300 weisen jeweils ein Interface auf, wobei das Interface 302 des Lesegeräts mit dem Interface 306 der Chipkarte 304 kommunizieren kann. Über diese beiden Interfaces ist somit ein Datenaustausch zwischen Lesegerät und Chipkarte möglich.

Die Chipkarte weist ferner einen Mikroprozessor 308 auf, der einen nicht näher dargestellten RAM-Speicher aufweist. Der Mikroprozessor 308 ist dazu ausgebildet, eine Datenkommunikation zwischen dem Interface 306 und den Speichern 310 bzw. 312 zu steuern.

Beim Speicher 310 handelt es sich um den obig beschriebenen ersten nichtflüchtigen, wiederbeschreibbaren Speicher, zum Beispiel einen EEPROM-Speicher, wohingegen es sich bei dem Speicher 312 um den zweiten nichtfiüchtigen, wiederbeschreibbaren Speicher, zum Beispiel einen FRAM-Speicher, handelt.

Es sei jedoch nochmals darauf hingewiesen, dass die Erfindung nicht auf die Verwendung einer Kommunikation von lediglich EEPROM- und FRAM-Speicher beschränkt ist. Vielmehr kann die Erfindung allgemein dadurch realisiert werden, dass der Speicher 312 so gewählt wird, dass er schneller ist als der Speicher 310. "Schneller" wird hierbei in Bezug auf Zugriffszeiten und/oder Datenleseraten und/oder Datenschreibraten verstanden.

### Bezugszeichenliste

- 300: Lesegerät
- 302: Interface
- 304: Chipkarte
- 306: Interface
- 308: Mikroprozessor
- 310: erster Speicher
- 312: zweiter Speicher

## Patentansprüche

1. Verfahren zum sicheren Speichern von Daten in einem ersten nichtflüchtigen, wieder beschreibbaren Speicher (310) einer Chipkarte (304), wobei die Chipkarte (304) ferner einen zweiten nichtflüchtigen, wieder beschreibbaren Speicher (312) aufweist, wobei sich der Speichertyp des ersten nichtflüchtigen, wieder beschreibbaren Speichers vom Speichertyp des zweiten nichtflüchtigen, wieder beschreibbaren Speichers unterscheidet, wobei das Verfahren die Schritte umfasst:
- Empfang (100) von Daten,
- Schreiben (102) der Daten in den zweiten Speicher (312),
- Registrieren (104) eines erfolgreichen Schreibvorgangs aller Daten in den zweiten Speicher (312),
- Schreiben (106) der Daten in den ersten Speicher (310),
- Registrieren (110) eines erfolgreichen Schreibvorgangs aller Daten in den ersten Speicher (310).

2. Verfahren nach Anspruch 1, wobei der zweite Speicher (312) schneller ist als der erste Speicher (310).

3. Verfahren nach Anspruch 1 oder 2, wobei das Registrieren des erfolgreichen Schreibvorgangs aller Daten in den zweiten Speicher (312) und das Registrieren des erfolgreichen Schreibvorgangs aller Daten in den ersten Speicher (310) über zumindest ein Flag erfolgt.

4. Verfahren nach Anspruch 3, wobei das Registrieren des erfolgreichen Schreibvorgangs aller Daten in den ersten Speicher (310) durch Löschen des Flags erfolgt, welcher zur Registrierung des erfolgreichen Schreibvorgangs aller Daten in den zweiten Speicher (312) gesetzt wurde.

5. Verfahren nach einem der vorigen Ansprüche, wobei es sich bei dem zweiten Speicher (312) um einen NVRAM-Speicher handelt.

6. Verfahren nach Anspruch 5, wobei es sich bei dem NVRAM-Speicher um einen FRAM oder MRAM oder PRAM Speicher handelt.

7. Verfahren nach einem der vorigen Ansprüche, wobei es sich bei dem ersten Speicher (310) um einen EEPROM oder einen Flash-EEPROM Speicher handelt.

8. Verfahren nach einem der vorigen Ansprüche, wobei überprüft wird (206), ob kein erfolgreicher Schreibvorgang aller Daten in den ersten Speicher (310) erfolgt ist, wobei in diesem Fall
- die Daten aus dem zweiten Speicher (312) gelesen werden (210),
- die aus dem zweiten Speicher (312) gelesenen Daten in den ersten Speicher (310) geschrieben werden (216),
- im Falle eines nun erfolgreichen Schreibvorgangs dieser Daten dieser erfolgreiche Schreibvorgang als der erfolgreiche Schreibvorgang aller Daten in den ersten Speicher (310) registriert wird (220).

9. Verfahren nach Anspruch 8, wobei vor Durchführung einer bestimmungsgemäßen Verwendung des ersten Speichers (310) die Überprüfung stattfindet, ob kein erfolgreicher Schreibvorgang aller Daten in den ersten Speicher (310) erfolgt ist.

10. Verfahren nach Anspruch 9, wobei die bestimmungsgemäßen Verwendung des ersten Speichers (310) ein Initialisierungsvorgang der Chipkarte (304) umfasst.

11. Verfahren nach einem der vorigen Ansprüche, wobei das Registrieren des erfolgreichen Schreibvorgangs aller Daten in den zweiten Speicher (312) und das Registrieren des erfolgreichen Schreibvorgangs aller Daten in den ersten Speicher (310) im zweiten Speicher (312) erfolgt.

12. Verfahren nach einem der vorigen Ansprüche, wobei der zweite Speicher (312) kleiner ist als der erste Speicher (310).

13. Computerprogrammprodukt mit von einem Prozessor ausführbaren Instruktionen zur Durchführung von Verfahrensschritten gemäß dem Verfahren nach einem der vorigen Ansprüche.

14. Chipkarte (304) zum sicheren Speichern von Daten in einem ersten nichtflüchtigen, wieder beschreibbaren Speicher (310) der Chipkarte (304), wobei die Chipkarte (304) ferner einen zweiten nichtflüchtigen, wieder beschreibbaren Speicher (312) aufweist, wobei sich der Speichertyp des ersten nichtflüchtigen, wieder beschreibbaren Speichers vom Speichertyp des zweiten nichtflüchtigen, wieder beschreibbaren Speichers unterscheidet, wobei die Chipkarte (304) ferner einen Mikroprozessor aufweist, welcher zur Durchführung der folgenden Schritte ausgebildet ist:
- Empfang (100) von Daten,
- Schreiben (102) der Daten in den zweiten Speicher (312),
- Registrieren (104) eines erfolgreichen Schreibvorgangs aller Daten in den zweiten Speicher (312),
- Schreiben (106) der Daten in den ersten Speicher (310),
- Registrieren (110) eines erfolgreichen Schreibvorgangs aller Daten in den ersten Speicher (310).

## Geänderte Patentansprüche

### Geänderte Patentansprüche gemäss Regel 137(2) EPÜ.

**1.** Verfahren zum sicheren Speichern von Daten in einem ersten nichtflüchtigen, wieder beschreibbaren Speicher (310) einer Chipkarte (304), wobei die Chipkarte (304) ferner einen zweiten nichtflüchtigen, wieder beschreibbaren Speicher (312) aufweist, wobei sich der Speichertyp des ersten nichtflüchtigen, wieder beschreibbaren Speichers vom Speichertyp des zweiten nichtflüchtigen, wieder beschreibbaren Speichers unterscheidet, wobei es sich bei dem zweiten Speicher (312) um einen FRAM-Speicher handelt, wobei das Verfahren die Schritte umfasst:
- Empfang (100) von Daten,
- Schreiben (102) der Daten in den zweiten Speicher (312),
- Registrieren (104) eines erfolgreichen Schreibvorgangs aller Daten in den zweiten Speicher (312),
- Schreiben (106) der Daten in den ersten Speicher (310),
- Registrieren (110) eines erfolgreichen Schreibvorgangs aller Daten in den ersten Speicher (310)
wobei das Registrieren des erfolgreichen Schreibvorgangs aller Daten in den zweiten Speicher (312) und das Registrieren des erfolgreichen Schreibvorgangs aller Daten in den ersten Speicher (310) im zweiten Speicher (312) erfolgt, wobei das Registrieren des erfolgreichen Schreibvorgangs aller Daten in den zweiten Speicher (312) und das Registrieren des erfolgreichen Schreibvorgangs aller Daten in den ersten Speicher (310) über zumindest ein Flag erfolgt, wobei das Registrieren des erfolgreichen Schreibvorgangs aller Daten in den ersten Speicher (310) durch Lesen und damit Löschen des Flags erfolgt, welcher zur Registrierung des erfolgreichen Schreibvorgangs aller Daten in den zweiten Speicher (312) gesetzt wurde.

**2.** Verfahren nach Anspruch 1, wobei der zweite Speicher (312) schneller ist als der erste Speicher (310).

**3.** Verfahren nach einem der vorigen Ansprüche, wobei es sich bei dem ersten Speicher (310) um einen EEPROM oder einen Fiash-EEPROM Speicher handelt,

**4.** Verfahren nach einem der vorigen Ansprüche, wobei überprüft wird (206), ob kein erfolgreicher Schreibvorgang aller Daten in den ersten Speicher (310) erfolgt ist, wobei in diesem Fall
- die Daten aus dem zweiten Speicher (312) gelesen werden (210),
- die aus dem zweiten Speicher (312) gelesenen Daten in den ersten Speicher (310) geschrieben werden (216),
- im Falle eines nun erfolgreichen Schreibvorgangs dieser Daten dieser erfolgreiche Schreibvorgang als der erfolgreiche Schreibvorgang aller Daten in den ersten Speicher (310) registriert wird (220).

**5.** Verfahren nach Anspruch 4, wobei vor Durchführung einer bestimmungsgemäßen Verwendung des ersten Speichers (310) die Überprüfung stattfindet, ob kein erfolgreicher Schreibvorgang aller Daten in den ersten Speicher (310) erfolgt ist.

**6.** Verfahren nach Anspruch 5, wobei die bestimmungsgemäßen Verwendung des ersten Speichers (310) ein Initialisierungsvorgang der Chipkarte (304) umfasst.

**7.** Verfahren nach einem der vorigen Ansprüche, wobei der zweite Speicher (312) kleiner ist als der erste Speicher (310).

**8.** Computerprogrammprodukt mit von einem Prozessor ausführbaren Instruktionen zur Durchführung von Verfahrensschritten gemäß dem Verfahren nach einem der vorigen Ansprüche.

**9.** Chipkarte (304) zum sicheren Speichern von Daten in einem ersten nichtflüchtigen, wieder beschreibbaren Speicher (310) der Chipkarte (304), wobei die Chipkarte (304) ferner einen zweiten nichtflüchtigen, wieder beschreibbaren Speicher (312) aufweist, wobei sich der Speichertyp des ersten nichtflüchtigen, wieder beschreibbaren Speichers vom Speichertyp des zweiten nichtflüchtigen, wieder beschreibbaren Speichers unterscheidet, wobei es sich bei dem zweiten Speicher (312) um einen FRAM-Speicher handelt, wobei die Chipkarte (304) ferner einen Mikroprozessor aufweist, welcher zur Durchführung der folgenden Schritte ausgebildet ist:
- Empfang (100) von Daten,
- Schreiben (102) der Daten in den zweiten Speicher (312),
- Registrieren (104) eines erfolgreichen Schreibvorgangs aller Daten in den zweiten Speicher (312),
- Schreiben (106) der Daten in den ersten Speicher (310),
- Registrieren (110) eines erfolgreichen Schreibvorgangs aller Daten in den ersten Speicher (310)
wobei das Registrieren des erfolgreichen Schreibvorgangs aller Daten in den zweiten Speicher (312) und das Registrieren des erfolgreichen Schreibvorgangs aller Daten in den ersten Speicher (310) im zweiten Speicher (312) erfolgt, wobei das Registrieren des erfolgreichen Schreibvorgangs aller Daten in den zweiten Speicher (312) und das Registrieren des erfolgreichen Schreibvorgangs aller Daten in den ersten Speicher (310) über zumindest ein Flag erfolgt, wobei das Registrieren des erfolgreichen Schreibvorgangs aller Daten in den ersten Speicher (310) durch Lesen und damit Löschen des Flags erfolgt, welcher zur Registrierung des erfolgreichen Schreibvorgangs aller Daten in den zweiten Speicher (312) gesetzt wurde.
